# EUROPÄISCHE PATENTSCHRIFT

(11) **EP 2 645 832 B1**
(45) Veröffentlichungstag und Bekanntmachung des Hinweises auf die Patenterteilung: **24.06.2020**
(21) Anmeldenummer: 13159727.0
(22) Anmeldetag: 18.03.2013
(51) Int. Cl.: H05K 5/00, F24C 7/08, F24C 15/10

(54) **Hausgerätevorrichtung**
Domestic appliance
Dispositif d'appareil ménager

(30) Priorität: 29.03.2012 ES 201230472
(43) Veröffentlichungstag der Anmeldung: 02.10.2013
(73) Patentinhaber: BSH Hausgeräte GmbH, 81739 München (DE)
(72) Erfinder: Arnal Valero, Adolfo, 50009 Zaragoza (ES); Ceamanos Gaya, Jesús, 50016 Zaragoza (ES); Llorente Gil, Sergio, 50009 Zaragoza (ES); Martin Gomez, Damaso, 20012 Zaragoza (ES); Palacios Tomas, Daniel, 50008 Zaragoza (ES); Pallares Zaera, Oscar, 50018 Zaragoza (ES)

(56) Entgegenhaltungen:
- EP-A1- 2 290 292
- EP-A1- 2 390 577
- EP-A2- 0 077 928
- EP-A2- 1 139 695
- EP-A2- 1 798 483
- WO-A1-97/43583
- DE-C1- 19 715 954
- DE-U1- 20 301 800
- US-A- 4 370 515
- US-A- 5 508 889
- US-A1- 2007 103 882
- US-B1- 6 239 359

## Beschreibung

Die Erfindung geht aus von einer Hausgerätevorrichtung nach dem Oberbegriff des Anspruchs 1.

Es sind Kochfelder bekannt, die ein Gehäuse und eine Elektronikeinheit, die in dem Gehäuse angeordnet ist, aufweisen. Weiterhin ist es bekannt, eine Elektronikbaugruppe der Elektronikeinheit gegen andere Elektronikbauteile der Elektronikeinheit durch Ausformungen des Gehäuses abzugrenzen. Dokument EP 2 390 577 A1 offenbart beispielsweise ein Gargerät mit einer Elektronikbaugruppe.

Die Aufgabe der Erfindung besteht insbesondere darin, eine gattungsgemäße Vorrichtung mit verbesserten Eigenschaften hinsichtlich einer erhöhten Sicherheit bereitzustellen. Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

Die Erfindung geht aus von einem Hausgerät mit einer Hausgerätevorrichtung, insbesondere einer Gargerätevorrichtung, mit zumindest einer Elektronikeinheit und zumindest einer Barriereeinheit, die dazu vorgesehen ist, zumindest eine Elektronikbaugruppe der Elektronikeinheit gegen zumindest einen Großteil anderer elektronischer Bauelemente der Elektronikeinheit abzugrenzen.

Es wird vorgeschlagen, dass die Barriereeinheit zumindest ein Raumstrukturierungselement aufweist, das dazu vorgesehen ist, einen von der Barriereeinheit zumindest im Wesentlichen umfassten Raum zu strukturieren. Unter einer "Elektronikeinheit" soll insbesondere eine Einheit verstanden werden, die von elektronischen Bauteilen, insbesondere Spulen, Wiederständen, Kondensatoren und/oder Halbleiterbauteilen, gebildet ist. Insbesondere weist die Elektronikeinheit zumindest ein Leistungsbauteil, insbesondere einen elektrischen Motor, ein elektrisches Heizelement, insbesondere einen Induktor, zumindest eine Leistungselektronik, insbesondere zur Energieversorgung des Leistungsbauteils, und/oder zumindest eine Steuerelektronik, insbesondere zur Steuerung des Leistungsbauteils und/oder der Leistungselektronik, auf.

Insbesondere weist die Elektronikeinheit zumindest eine Leiterplatte auf, die dazu vorgesehen ist, zumindest einen Teil der elektrischen Bauteile der Elektronikeinheit zu tragen, elektrisch leitend miteinander zu verbinden und/oder zu bilden. Insbesondere ist die Leiterplatte Teil der Barriereeinheit. Unter einer "Elektronikbaugruppe" soll insbesondere eine Reihen- und/oder Parallelschaltung von zumindest einem, insbesondere zumindest zwei, vorteilhaft zumindest drei, besonders vorteilhaft zumindest vier, vorzugsweise zumindest fünf, insbesondere maximal 20, vorteilhaft maximal 15, vorzugsweise maximal 10, elektronischen Bauelementen verstanden werden, die einem gemeinsamen Zweck dienen. Insbesondere ist die Barriereeinheit dazu vorgesehen, die Elektronikbaugruppe gegen leitfähige Gehäuseteile und/oder gegen Teile, die leitfähig mit leitfähigen Gehäuseteilen verbunden sind, abzugrenzen. Insbesondere weist die Barriereeinheit zumindest eine Ablagerungsfläche auf, die zwischen der Elektronikbaugruppe und einem elektronischen Bauteil der Elektronikeinheit und/oder einem Gehäuseteil der Gehäuseeinheit, das durch die Barriereeinheit von der Elektronikbaugruppe abgegrenzt wird, angeordnet ist. Darunter, dass eine Fläche "zwischen" zwei Bauelementen und/oder zwischen einem Bauelement und der Elektronikbaugruppe angeordnet ist, soll insbesondere verstanden werden, dass jedes Strahlbündel mit einem Durchmesser von zumindest 0,1 mm, insbesondere zumindest 0,5 mm, vorteilhaft zumindest 1 mm, das die Bauelemente miteinander und/oder das Bauelement mit zumindest einem beliebigen der Bauelemente der Elektronikbaugruppe verbindet, die Fläche zumindest teilweise schneidet. Insbesondere ist die Barriereeinheit dazu vorgesehen, die Elektronikbaugruppe gegen zumindest 70 %, vorteilhaft zumindest 85%, besonders vorteilhaft zumindest 95 %, vorzugsweise 100 %, der anderen elektronischen Bauelemente und/oder der Bauteile, die als Gehäusebauteile ausgebildet und/oder leitend mit zumindest einem Gehäusebauteile verbunden sind und die einen Abstand von maximal zumindest 5 cm, insbesondere zumindest 10 cm, vorteilhaft zumindest 20 cm, zu der Elektronikbaugruppe aufweisen, abzugrenzen. Insbesondere ist die Ablagerungsfläche dazu vorgesehen, von der Elektronikbaugruppe, insbesondere bei einem, insbesondere kontrollierten und/oder gewolltem, Defekt, emittierte Ionen und/oder Plasma zu adsorbieren. Insbesondere ist die Barriereeinheit dazu vorgesehen, ein Volumen bereitzustellen, in dem sich das Plasma und/oder die Ionen ausbreiten und verdünnen können. Vorzugsweise unterscheidet sich die Barriereeinheit von einer Lackschicht und/oder etwas vergleichbarem, die auf die Elektronikbaugruppe aufgetragen ist. Unter einem "Raumstrukturierungselement" soll insbesondere ein Teil der Barriereinheit verstanden werden, der dazu vorgesehen ist, eine innere Oberfläche eines, von der Barriereeinheit zumindest im Wesentlichen umfassten Raums zu vergrößern. Insbesondere ist das Raumstrukturierungselement dazu vorgesehen, zusätzliche Anlagerungsflächen bereitzustellen. Insbesondere ist das Raumstrukturierungselement als aus einer Wand der Barriereeinheit herausstehende Rippe ausgebildet. Es kann insbesondere eine erhöhte Sicherheit erreicht werden, da eine Gesamtfläche der Anlagerungsflächen vergrößert wird und somit eine verbesserte Adsorption von im Falle eines Defekts emittierten Ionen und/oder Plasmas erreicht wird.

Weiterhin wird vorgeschlagen, dass zumindest die eine Elektronikbaugruppe als Schutzbaugruppe ausgebildet ist. Unter einer Schutzbaugruppe soll insbesondere eine Elektronikbaugruppe verstanden werden, die dazu vorgesehen ist, zumindest einen elektrischen Schaltkreis, der insbesondere zumindest ein Leistungsbauteil aufweist, vor einer Überspannung und/oder vorzugsweise einem Überstrom, insbesondere einer Stromstärke größer als 32 A, insbesondere größer als 25 A, vorteilhaft größer als 20 A, besonders vorteilhaft größer als 16 A, vorzugsweise größer als 10 A, insbesondere ausgelöst durch einen Defekt und/oder Fehler eines anderen elektronischen Bauteils, insbesondere eines elektronischen Bauteils der Leistungselektronik, insbesondere einem Inverter, und/oder einem elektronischen Bauteil der Steuerelektronik, der zu einer Fehlansteuerung führt, zu schützen. Insbesondere ist die Schutzbaugruppe dazu vorgesehen, eine Stromleitung einer Spannungsversorgung, insbesondere eines Hausstromanschlusses, eine Stromleitung eines Spannungswandlers und/oder eine Stromleitung eines Leistungsbauteils zu schützen. Auch sind Schutzbaugruppen denkbar, die bereits bei kleinen Stromstärken, insbesondere bei einem Überschreiten von 1 A oder einem Überschreiten von 0,5 A, eine Trennung der Stromleitung vornehmen. Insbesondere ist die Schutzbaugruppe als Überstromschutzeinrichtung ausgebildet. Alternativ sind Ausgestaltungen als Überspannungsschutzeinrichtung, beispielsweise mit Freilaufdioden, denkbar. Insbesondere weist die Schutzbaugruppe ein elektronisches Bauelement, insbesondere einen elektrischen Leiter, auf, das dazu vorgesehen ist, sich bei einem Überstrom selbst zu zerstören, insbesondere durch Überhitzung zu verdampfen, um eine leitende Verbindung zu unterbrechen. Um eine erhöhte Sicherheit zu gewährleisten, weist die Schutzbaugruppe bevorzugt eine Mehrzahl von in Reihe geschalteten elektronischen Bauelementen auf, die dazu vorgesehen sind, bei einem Überstrom eine Verbindung zu trennen. Besonders beschriebene Schutzbauteile sind einem erhöhten Risiko ausgesetzt, zerstört zu werden. Um eine erhöhte Sicherheit zu gewährleisten, findet die Erfindung hier vorteilhaft Anwendung.

Ferner wird vorgeschlagen, dass das zumindest eine Raumstrukturierungselement dazu vorgesehen ist, zumindest in einem montierten Zustand zumindest zwei Elektronikelemente der Elektronikbaugruppe gegeneinander abzugrenzen. Insbesondere weist das Raumstrukturierungselement zumindest eine Anlagerungsfläche auf, die zumindest zwischen den zwei Elektronikelementen angeordnet ist. Es kann insbesondere eine erhöhte Sicherheit erreicht werden. Insbesondere kann erreicht werden, dass eine, durch von den unterschiedlichen elektronischen Bauelementen im Falle eines gleichzeitigen Defekts emittiertes Plasma, mögliche Funkenstrecke verlängert und/oder unterbunden wird.

Weiterhin wird vorgeschlagen, dass die Barriereeinheit und eine Gehäuseeinheit, die dazu vorgesehen ist, die Elektronikeinheit zumindest großteils aufzunehmen, getrennt voneinander ausgebildet sind. Unter einer "Gehäuseeinheit" einer Hausgerätevorrichtung soll insbesondere eine Einheit verstanden werden, die von zumindest einem Gehäuseteil gebildet ist, die gemeinsam einen Raum bilden, der dazu vorgesehen ist, weitere Bauteile der Hausgerätevorrichtung aufzunehmen. Vorzugsweise sind die Gehäuseteile jeweils an zumindest einer Fläche durch einen Bediener von außen, zumindest in einem montierten Zustand der Hausgerätevorrichtung, vorteilhaft in einem Zustand, der sich von einem Einbauzustand, in dem die Hausgerätevorrichtung in ein Möbelstück integriert ist, unterscheidet, berührbar. Insbesondere ist zumindest eines der Gehäuseteile als Kochfeldplatte und/oder Hausgerätetür ausgebildet. Es kann insbesondere eine freie Platzierbarkeit der Baugruppe innerhalb der Elektronikeinheit erreicht werden. Insbesondere können Entwicklungskosten für eine individuelle Anpassung von Gehäuseeinheiten eingespart werden. Alternativ ist es denkbar, dass die Gehäuseeinheit zumindest ein, insbesondere zumindest im Wesentlichen aus Kunststoff, gefertigtes Gehäuseteil aufweist, das speziell ausgebildet ist und zumindest ein Barriereelement der Barriereeinheit bildet.

Ferner wird vorgeschlagen, dass zumindest die eine Elektronikbaugruppe als Leiterbahnbaugruppe ausgebildet ist. Unter einer Leiterbahnbaugruppe soll insbesondere eine Elektronikbaugruppe verstanden werden, deren zumindest ein elektronisches Bauelement von zumindest einer Leiterbahn auf einer Leiterplatte gebildet ist. Insbesondere sind durch eine Breite und/oder Führung der Leiterbahn unterschiedliche Wiederstände, Kapazitäten und/oder Induktivitäten einstellbar. Insbesondere ist die Leiterbahn als elektrischer Wiederstand ausgebildet, der dazu vorgesehen ist, als Überstromschutzeinrichtung zu fungieren. Alternativ ist es denkbar, dass die Leiterbahn als Induktionsspule, insbesondere für einen Stromsensor, ausgebildet ist. Eine Zerstörung dieser Bauelemente, insbesondere durch eine Überspannung, führt, insbesondere auch wenn sie mit einem mechanischen Schutzlack versehen sind, zu einer Freisetzung von Plasma, das leitende Verbindungen zu anderen elektronischen Bauteilen und/oder Gehäusebauteilen herstellen kann. Um eine erhöhte Sicherheit zu gewährleisten, findet die Erfindung hier vorteilhaft Anwendung.

Weiterhin wird vorgeschlagen, dass die Barriereeinheit zumindest ein Barriereelement mit zumindest einem Befestigungselement aufweist, das dazu vorgesehen ist, das Barriereelement mit der Elektronikeinheit zu verbinden. Unter einem Barriereelement soll insbesondere ein Element der Barriereeinheit mit zumindest einer Ablagerungsfläche verstanden werden. Insbesondere ist das Befestigungselement dazu vorgesehen, das Barriereelement mit einer Leiterplatte der Elektronikeinheit zu verbinden. Es kann insbesondere eine preiswerte Befestigung erreicht werden. Insbesondere kann eine erhöhte Sicherheit erreicht werden. Alternativ ist eine Stoffschlussverbindung, insbesondere eine Klebeverbindung, denkbar, um die Barriereeinheit mit der Elektronikeinheit zu verbinden.

Ferner wird vorgeschlagen, dass das Befestigungselement als Rastelement ausgebildet ist. Insbesondere ist das Befestigungselement dazu vorgesehen, mit einem korrespondierenden Rastelement der Elektronikeinheit, insbesondere einem Loch in der Leiterplatine, eine formschlüssige Verbindung einzugehen. Alternativ ist es denkbar, dass das Befestigungselement als Klemmelement ausgebildet ist. Insbesondere ist es denkbar, dass das Befestigungselement dazu vorgesehen ist, mit einem korrespondierenden Klemmelement der Elektronikeinheit eine kraftschlüssige Verbindung einzugehen. Es kann insbesondere eine preiswerte, sichere Lösung bereitgestellt werden.

Weiterhin wird vorgeschlagen, dass die Barriereeinheit zumindest in dem montierten Zustand als zumindest im Wesentlichen geschlossene Umhüllung ausgebildet ist.

Insbesondere sind zumindest von jedem Bauelement der Elektronikbaugruppe gesehen, vorteilhaft von jedem Punkt innerhalb der Barriereeinheit gesehen, zumindest 95 %, vorteilhaft zumindest 97 %, vorzugsweise zumindest 99 %, des vollen Raumwinkels durch zumindest eine Anlagerungsfläche der Barriereeinheit begrenzt. Es kann insbesondere eine gute Eindämmung für emittierte Ionen und/oder emittiertes Plasma erreicht werden.

Alternativ wird vorgeschlagen, dass die Barriereeinheit zumindest in dem montierten Zustand als teilweise offene Umhüllung ausgebildet ist. Insbesondere sind von zumindest jedem Bauelement der Elektronikbaugruppe gesehen maximal 95 %, insbesondere maximal 90 %, und vorteilhaft zumindest 50 %, besonders vorteilhaft zumindest 70 %, vorzugsweise zumindest 85 %, des vollen Raumwinkels durch zumindest eine Anlagerungsfläche der Barriereeinheit begrenzt. Es kann insbesondere eine gute Wärmeabführung von der Elektronikbaugruppe, insbesondere durch Konvektion und/oder Luftbewegung, erreicht werden.

Weiterhin wird vorgeschlagen, dass die Barriereeinheit zumindest im Wesentlichen aus Kunststoff gebildet ist. Insbesondere weist die Barriereeinheit zumindest ein Barriereelement auf, das zu mindestens 50 %, vorteilhaft mindestens 70 %, vorzugsweise mindestens 85 %, von Kunststoff, insbesondere faserverstärktem Kunststoff, vorteilhaft einem Harz, insbesondere Epoxidharz und/oder Phenolharz, alternativ einem Thermoplast, beispielsweise Polybutylenterephthalat oder Polyamid, gebildet ist. Insbesondere weisen die Materialien der Barriereelemente der Barriereeinheit eine Brennbarkeit der V0-Klasse auf. Insbesondere weisen die Materialien der Barriereelemente der Barriereeinheit eine Glühdrahtentzündungstemperatur von zumindest 700 °C, insbesondere zumindest 750 °C, vorteilhaft von zumindest 775 °C, auf. Insbesondere weisen die Materialien der Barriereelemente der Barriereeinheit eine Glühdrahtentflammbarkeitszahl von zumindest 750 °C, insbesondere zumindest 800 °C, vorteilhaft von zumindest 850 °C, auf. Es kann insbesondere eine leichte, preiswerte, einfach zu produzierende Ausgestaltung erreicht werden.

Die Erfindung findet Anwendung in elektrischen Hausgeräten, insbesondere Gargeräten, beispielsweise Mikrowellenherden, Backöfen und/oder Kochfeldern. Weiterhin ist ein Einsatz der Erfindung in Kühlschränken, Geschirrspülern, Waschmaschinen und weiteren Hausgeräten möglich.

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein erfindungsgemäßes Kochfeld in einer perspektivischen Darstellung,
- Fig. 2: eine erfindungsgemäße Kochfeldvorrichtung mit zwei unterschiedlich ausgestalteten erfindungsgemäßen Barriereeinheiten in einer perspektivischen Darstellung,
- Fig. 3: eine geschnittene Aufsicht entlang der Richtung III auf eine erste der Barriereeinheiten aus Figur 2,
- Fig. 4: eine perspektivische Darstellung eines erfindungsgemäßen Barriereelements einer Barriereeinheit nach Figur 3,
- Fig. 5: eine geschnittene Aufsicht entlang der Richtung V auf eine zweite der Barriereeinheiten aus Figur 2,
- Fig. 6: eine perspektivische Darstellung eines erfindungsgemäßen Barriereelements einer Barriereeinheit nach Figur 5 und
- Fig. 7: eine perspektivische Darstellung eines alternativen, erfindungsgemäßen Barriereelements.

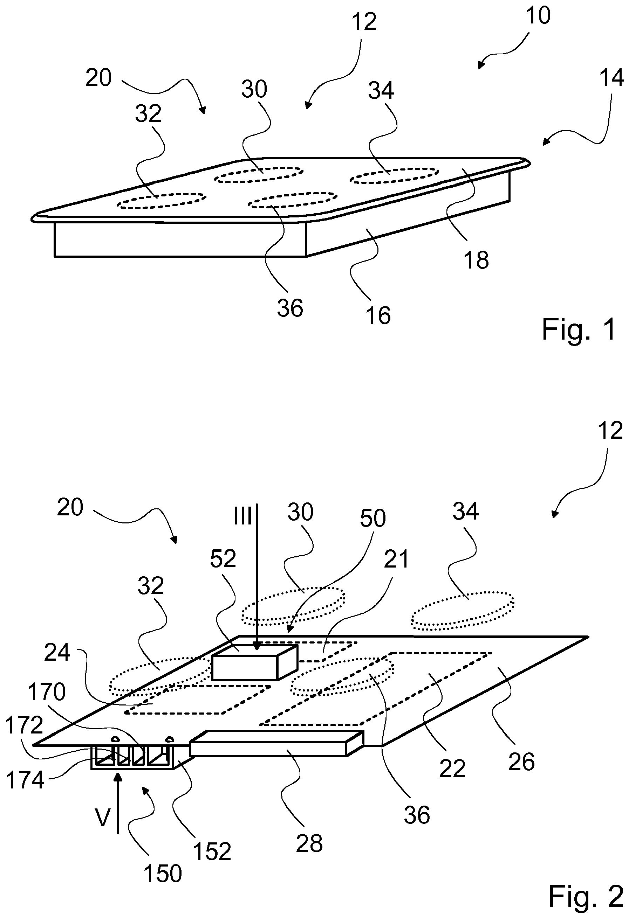

Figur 1 zeigt ein als Kochfeld ausgebildetes Hausgerät 10 mit einer als Kochfeldvorrichtung ausgebildeten Hausgerätevorrichtung 12. Die Hausgerätevorrichtung 12 weist eine Gehäuseeinheit 14 auf. Weiterhin weist die Hausgerätevorrichtung 12 eine Elektronikeinheit 20 auf. Die Elektronikeinheit 20 ist komplett in der Gehäuseeinheit 14 angeordnet. Die Gehäuseeinheit 14 ist von einem ersten, als Aluminiumschale ausgebildeten Gehäuseteil 16 und einem zweiten, als Kochfeldplatte ausgebildeten Gehäuseteil 18 gebildet. Die Elektronikeinheit 20 weist vier, als Heizelemente ausgebildete Leistungsbauteile 30, 32, 34, 36 auf. Die Leistungsbauteile 30, 32, 34, 36 sind unter dem als Kochfeldplatte ausgebildeten Gehäuseteil 18 angeordnet. Durch die Leistungsbauteile 30, 32, 34, 36 sind Kochzonen auf der Kochfeldplatte definiert. Die Leistungsbauteile 30, 32, 34, 36 sind als Induktionsheizelemente ausgebildet. Weiterhin weist die Elektronikeinheit 20 eine Netzanschlusselektronik 21 auf, die dazu vorgesehen ist, an einen Hausstromanschluss angeschlossen zu werden.

Die Elektronikeinheit 20 weist ferner eine Leistungselektronik 22 auf, die dazu vorgesehen ist, die Leistungsbauteile 30, 32, 34, 36 zu versorgen (Figur 2). Die Elektronikeinheit 20 weist weiterhin eine Steuerelektronik 24 auf, die dazu vorgesehen ist, die Leistungselektronik 22 zu steuern. Die Elektronikeinheit 20 weist eine Leiterplatte 26 auf, auf der die Leistungselektronik 22 und die Steuerelektronik 24 angeordnet ist. Die Leiterplatte 26 verbindet Bauelemente der Steuerelektronik 24 untereinander, Bauelemente der Leistungselektronik 22 untereinander und Bauelemente der Steuerelektronik 24 mit Bauelementen der Leistungselektronik 22 miteinander. Am Rand der Elektronikeinheit 20 bzw. am Rand der Leiterplatte 26 ist eine Kühleinheit 28 angeordnet, die zur Kühlung der Leistungselektronik 22 vorgesehen ist. Die Kühleinheit 28 weist einen Kühlkörper und einen Lüfter auf.

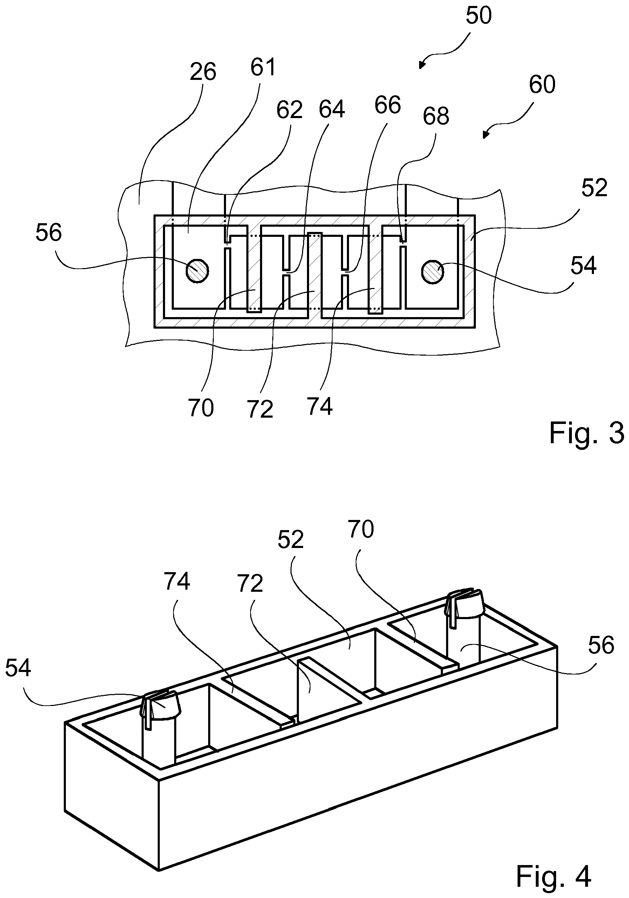

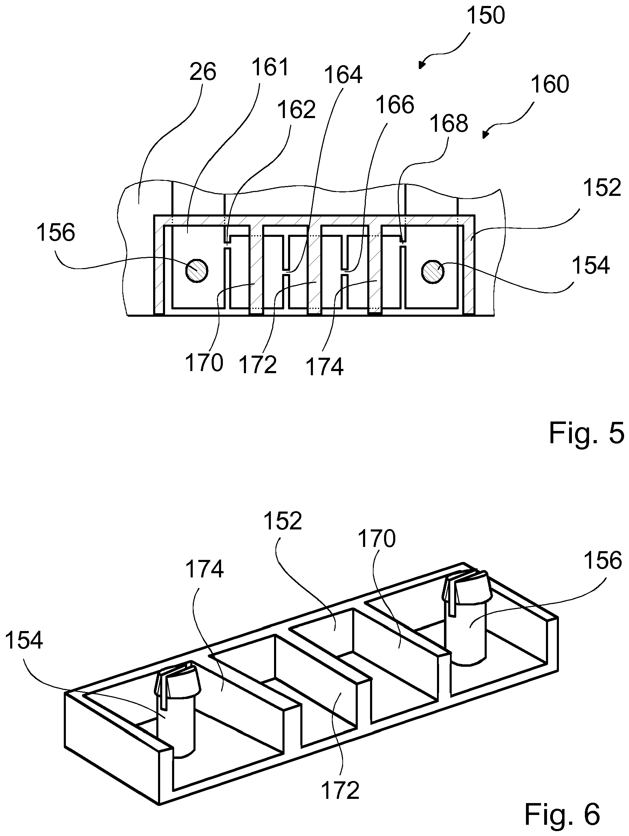

Die Elektronikeinheit 20 weist ein erste und eine zweite Barriereeinheit 50, 150 auf, die dazu vorgesehen ist, in einem montierten Zustand jeweils zumindest eine Elektronikbaugruppe 60, 160 der Elektronikeinheit 20 gegen alle anderen elektronischen Bauelemente der Elektronikeinheit 20 abzugrenzen. Die Barriereeinheiten 50, 150 sind jeweils von der Gehäuseeinheit 14 getrennt ausgebildet. Die Elektronikbaugruppen 60, 160 sind jeweils als Schutzbaugruppe ausgebildet (Figur 3 und 5). Die Elektronikbaugruppen 60, 160 sind als Überstromeinrichtungen ausgebildet. Die Elektronikbaugruppen 60, 160 sind als Leiterbahnbaugruppen ausgebildet. Die Elektronikbaugruppen 60, 160 weisen jeweils 4 von einer Leiterbahn 61, 161 gebildete, als Sicherungen ausgebildete, Elektronikelemente 62, 64, 66, 68, 162, 164, 166, 168 auf. Die Elektronikelemente 62, 64, 66, 68, 162, 164, 166, 168 sind als schmale Stellen der Leiterbahn 61, 161 ausgebildet. Die Elektronikelemente 62, 64, 66, 68, 162, 164, 166, 168 sind jeweils in Reihe geschaltet. Es sind Ausgestaltungen mit anderer Anzahl an Elektronikelementen, insbesondere zumindest eines, vorteilhaft fünf, aber auch bis zu zehn, denkbar.

Die Barriereeinheiten 50, 150 sind jeweils von der Leiterplatte 26 und einem weiteren Barriereelement 52, 152 gebildet. Die Barriereeinheiten 50, 150 sind im Wesentlichen aus Kunststoff gebildet ist. Die Leiterplatte 26 ist aus faserverstärktem Epoxidharz gebildet.

Das Barriereelement 52, 152 ist jeweils aus PBT gebildet. Das Barriereelement 52, 152 weist jeweils zwei Befestigungselemente 54, 56, 154, 156 auf, die dazu vorgesehen sind, das Barriereelement 52, 152 mit der Elektronikeinheit 20 zu verbinden. Die Befestigungselemente 54, 56, 154, 156 sind als Rastelemente ausgebildet. Die Leiterplatte 26 weist korrespondierende, als Löcher ausgebildete Rastmittel auf. Die Befestigungselemente 54, 56, 154, 156 sind einstückig mit den Barriereelementen 52, 152 ausgebildet. Die Befestigungselemente 54, 56, 154, 156 sind als geschlitzte Zapfen ausgebildet. Die Befestigungselemente 54, 56, 154, 156 weisen nahe dem geschlitzten Ende an der Außenkante einen Rastvorsprung auf, der zum Ende hin konisch zuläuft. Bei einer Montage der Barriereelemente 52, 152, bei Stecken der Befestigungselemente 54, 56, 154, 156 durch die korrespondierenden Löcher in der Leiterplatte 26, werden die geschlitzten Zapfen durch den Konus auf der flachen Seite des Rastvorsprungs zum Schlitz hin ausgelenkt. Passiert der Rastvorsprung das Loch der Leiterplatte 26 federt dieser nach außen und verrastet das Barriereelement 52, 152 mit der Leiterplatte 26, bzw. der Elektronikeinheit 20. Durch einen Konus auf der steilen Seite des Rastvorsprungs wird eine Federkraft erzeugt, die das Barriereelement 52, 152 gegen die Leiterplatte 26 presst.

Die erste Barriereeinheit 50 ist in dem montierten Zustand als im Wesentlichen geschlossene Umhüllung ausgebildet (Figuren 3 und 4). Die Barriereeinheit 50 ist dazu vorgesehen, die auf einer Oberseite der Leiterplatte 26 zwischen anderen elektronischen Bauelementen der Elektronikeinheit 20 angeordnete Elektronikbaugruppe 60 gegen die anderen elektronischen Bauelemente abzugrenzen. Das Barriereelement 52 der Barriereeinheit 50 ist als einseitig offener, länglicher Kasten ausgebildet. Das Barriereelement 52 ist auf der Oberseite der Leiterplatte 26, an der ein Großteil der anderen elektronischen Bauelemente der Elektronikeinheit 20 angeordnet ist, angeordnet. Das Barriereelement 52 ist mit der offenen Seite in Richtung der Leiterplatte 26 ausgerichtet. Das Barriereelement 52 weist in einem montierten Zustand, ausgehend von der Leiterplatte 26, eine Höhe von 22 mm auf. Die Barriereeinheit 50 weist drei Raumstrukturierungselemente 70, 72, 74 auf, die dazu vorgesehen sind, einen von der Barriereeinheit 50 umfassten Raum zu strukturieren. Die Raumstrukturierungselemente 70, 72, 74 sind jeweils als Innenwand ausgebildet, die sich ausgehend von einer Seitenwand des Barriereelements 52 über die gesamte montierte Höhe des Barriereelements 52 in den von der Barriereeinheit 50 umfassten Raum fast bis zur gegenüberliegenden Seitenwand des Barriereelements 52 erstreckt. Die Raumstrukturierungselemente 70, 74 erstrecken sich von einer ersten Seitenwand ausgehend, während das dazwischen angeordnete Raumstrukturierungselement 72 sich ausgehend von einer der ersten Seitenwand gegenüberliegenden Seitenwand erstreckt. Die Raumstrukturierungselemente 70, 72, 74 sind einstückig mit dem Barriereelement 52 ausgebildet. Durch die Spalte zwischen den Seitenwänden und den Raumstrukturierungselementen 70, 72, 74 wird jeweils ein verbessertes thermisches Verhalten erreicht. Die Raumstrukturierungselemente 70, 72, 74 sind dazu vorgesehen, in einem montierten Zustand jeweils zwei Elektronikelemente 62, 64, bzw. 64, 66, bzw. 66, 68 der Elektronikbaugruppe 60 gegeneinander abzugrenzen. Die Raumstrukturierungselemente 70, 72, 74 bilden Anlagerungsflächen, die zwischen den entsprechenden Elektronikelementen 62, 64, 66, 68 angeordnet sind. An der Oberseite der Leiterplatte 26 steht viel Bauraum zur Verfügung, da hier auch andere hohe elektronische Bauelemente verbaut sind. Dies wiederum ermöglicht eine Ausgestaltung des Barriereelements 52 mit dieser Höhe. Durch die große Höhe kann sich bei einem Schaden, also einem Verdampfen, des Elektronikelements 62, 64, 66, 68 entstehendes Plasma gut verteilen und der Stromfluss, insbesondere durch einen Lichtbogen, wird schnell unterdrückt. Eine Breite und eine Länge des Barriereelements 52 betragen 2 cm und 5 cm. In Abhängigkeit von einer Ausgestaltung der Elektronikbaugruppe 60 können Breite und Länge des Barriereelements 52 zwischen 5 mm und 35 mm, bzw. zwischen 2 cm und 10 cm liegen. Die Raumstrukturierungselemente 70, 72, 74 unterteilen den von der Barriereeinheit 50 umschlossenen Raum in vier Teilräume, in denen jeweils eines der Elektronikelemente 62, 64, 66, 68 angeordnet ist. Die Befestigungselemente 54, 56 sind nahe Endbereichen des Barriereelements 52 an einer Innenseite angeordnet. Die Befestigungselemente 54, 56 sind in einem ersten und einem vierten, bzw. letzten der Teilräume angeordnet.

Die zweite Barriereeinheit 150 ist in dem montierten Zustand als teilweise offene Umhüllung ausgebildet (Figuren 5 und 6). Die Barriereeinheit 150 ist dazu vorgesehen, eine auf einer Unterseite der Leiterplatte 26 in einem Randbereich der Elektronikeinheit 20 angeordnete Elektronikbaugruppe 160 gegen andere elektronische Bauelemente abzugrenzen. Die Elektronikbaugruppe 160 ist in einem Randbereich der Leiterplatte 26 angeordnet. Das Barriereelement 152 der Barriereeinheit 150 ist als zweiseitig offener, länglicher Kasten ausgebildet, wobei die beiden offenen Seiten aneinander grenzen. Die beiden offenen Seiten sind Längsseiten des Barriereelements 152. Das Barriereelement 152 ist auf der Unterseite der Leiterplatte 26, an der nur wenige der anderen elektronischen Bauelemente der Elektronikeinheit 20 angeordnet sind, angeordnet. Das Barriereelement 152 ist mit der breiteren der offenen Seiten in Richtung der Leiterplatte 26 ausgerichtet. Die andere offene Seite ist zum nächsten Rand der Leiterplatte 26 hin ausgerichtet. Das Barriereelement 152 schließt an den Rand der Leiterplatte 26 an. Das Barriereelement 152 ist neben der Kühleinheit 28 angeordnet. Das Barriereelement 152 weist in einem montierten Zustand, ausgehend von der Leiterplatte 26, eine Höhe von 4 mm auf. Die Barriereeinheit 150 weist drei Raumstrukturierungselemente 170, 172, 174 auf, die dazu vorgesehen sind, einen von der Barriereeinheit 150 umfassten Raum zu strukturieren. Die Raumstrukturierungselemente 170, 172, 174 sind jeweils als Innenwand ausgebildet, die sich ausgehend von einer Seitenwand des Barriereelements 152 über die gesamte montierte Höhe des Barriereelements 152 in den von der Barriereeinheit 150 umfassten Raum bis zur gegenüberliegenden offenen Seitenwand des Barriereelements 152 erstreckt. Die Raumstrukturierungselemente 170, 172, 174 sind einstückig mit dem Barriereelement 152 ausgebildet. Die Raumstrukturierungselemente 170, 172, 174 sind dazu vorgesehen, in einem montierten Zustand jeweils zwei Elektronikelemente 162, 164, bzw. 164, 166, bzw. 166, 168 der Elektronikbaugruppe 160 gegeneinander abzugrenzen. Die Raumstrukturierungselemente 170, 172, 174 bilden Anlagerungsflächen, die zwischen den entsprechenden Elektronikelementen 162, 164, 166, 168 angeordnet sind. An der Unterseite der Leiterplatte 26 steht nur wenig Bauraum zur Verfügung, da hier die Gehäuseeinheit 14 nahe ist. Die Raumstrukturierungselemente 170, 172, 174 unterteilen den von der Barriereeinheit 150 umschlossenen Raum in vier Teilräume, in denen jeweils eines der Elektronikelemente 162, 164, 166, 168 angeordnet ist. Die Befestigungselemente 154, 156 sind nahe Endbereichen des Barriereelements 152 an einer Innenseite angeordnet. Die Befestigungselemente 154, 156 sind in einem ersten und einem vierten, bzw. letzten der Teilräume angeordnet. Durch die Öffnung zur Seite kann sich bei einem Schaden, also einem Verdampfen, des Elektronikelements 162, 164, 166, 168 entstehendes Plasma gut verteilen und der Stromfluss, insbesondere durch einen Lichtbogen, wird schnell unterdrückt. Ebenso verhindert die Barriereeinheit 150 einen Lichtbogen zwischen einer defekten Elektronikbaugruppe 160 und der Gehäuseeinheit 14.

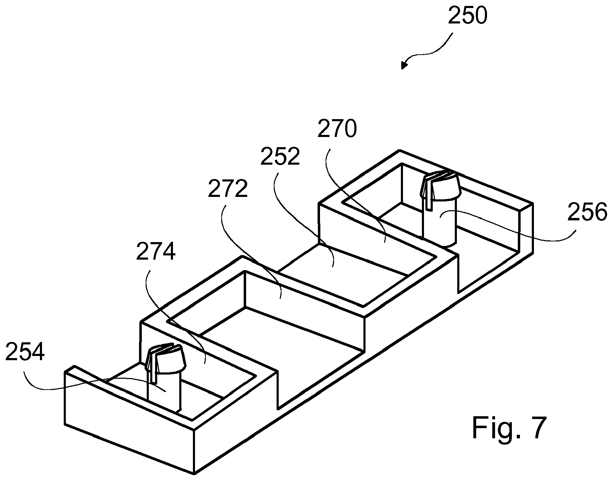

In Figur 7 ist ein weiteres erfindungsgemäßes Barriereelement 252 dargestellt. Das Barriereelement 252 weist drei Raumstrukturierungselemente 270, 272, 274 auf. Die Raumstrukturierungselemente 270, 272, 274 sind einstückig an das Barriereelement 252 angeformt. Das Barriereelement 252 ist als Kasten ausgebildet, der an einer Grundseite offen ist. Das Barriereelement 252 ist dazu vorgesehen, mit der Grundseite voran an eine Leiterplatte montiert zu werden und mit dieser eine Barriereeinheit 250 zu bilden. Das Barriereelement 252 bildet gemeinsam mit den Raumstrukturierungselementen 270, 272, 274 vier Teilräume aus, die in einer Reihe angeordnet sind. Die Teilräume sind abwechselnd in entgegengesetzte Richtungen offen ausgebildet. In einem ersten und einem letzten der Teilräume ist jeweils ein Befestigungselement 254, 256 angeordnet.

Weiterhin sind Ausgestaltungen denkbar, in denen ein Gehäuseteil eine oder mehrere mit den Barriereelementen 52, 152, 252 vergleichbare Ausformungen aufweist, die dazu vorgesehen sind, insbesondere gemeinsam mit einer Leiterplatte, eine Barriereeinheit zu bilden.

In alternativen Ausgestaltungen ist es denkbar, dass ein Barriereelement kleine Löcher, insbesondere Nadellöcher, aufweist, um eine Wärmeabfuhr zu verbessern. Weiterhin ist es denkbar, eine Barriereeinheit vergleichbar der ersten Barriereeinheit 50 auf der Unterseite der Leiterplatte 26 anzuordnen, wobei eine Höhe eines Barriereelements auf 4 mm beschränkt ist. Ebenso ist es denkbar, eine Barriereeinheit vergleichbar der zweiten Barriereeinheit 150 in einem Randbereich auf der Oberseite der Leiterplatte anzuordnen, wobei eine größerer Höhe, insbesondere in Anbetracht besserer Platzverhältnisse, von bis zu 22 mm oder mehr Anwendung finden kann. Als Oberseite soll hierbei jeweils die Seite der Leiterplatte 26 verstanden werden, auf der die meisten elektronischen Bauelemente angeordnet sind.

In einer weiteren Ausgestaltungsform ist es denkbar, dass eine von einer Leiterbahn gebildete Sicherung zusätzlich zu einer Einhüllung mit einer Barriereinheit mit einer Kaptonfolie und/oder etwas vergleichbarem überklebt ist, um verbesserte Sicherungseigenschaften zu erreichen.

**Bezugszeichen**

| | | | |
|---|---|---|---|
| 10 | Hausgerät | 72 | Raumstrukturierungselement |
| 12 | Hausgerätevorrichtung | 74 | Raumstrukturierungselement |
| 14 | Gehäuseeinheit | 150 | Barriereeinheit |
| 16 | Gehäuseteil | 152 | Barriereelement |
| 18 | Gehäuseteil | 154 | Befestigungselement |
| 20 | Elektronikeinheit | 156 | Befestigungselement |
| 21 | Netzanschlusselektronik | 160 | Elektronikbaugruppe |
| 22 | Leistungselektronik | 161 | Leiterbahn |
| 24 | Steuerelektronik | 162 | Elektronikelement |
| 26 | Leiterplatte | 164 | Elektronikelement |
| 28 | Kühleinheit | 166 | Elektronikelement |
| 30 | Leistungsbauteil | 168 | Elektronikelement |
| 32 | Leistungsbauteil | 170 | Raumstrukturierungselement |
| 34 | Leistungsbauteil | 172 | Raumstrukturierungselement |
| 36 | Leistungsbauteil | 174 | Raumstrukturierungselement |
| 50 | Barriereeinheit | 250 | Barriereeinheit |
| 52 | Barriereelement | 252 | Barriereelement |
| 54 | Befestigungselement | 254 | Befestigungselement |
| 56 | Befestigungselement | 256 | Befestigungselement |
| 60 | Elektronikbaugruppe | 270 | Raumstrukturierungselement |
| 61 | Leiterbahn | 272 | Raumstrukturierungselement |
| 62 | Elektronikelement | 274 | Raumstrukturierungselement |
| 64 | Elektronikelement | | |
| 66 | Elektronikelement | | |
| 68 | Elektronikelement | | |
| 70 | Raumstrukturierungselement | | |

## Patentansprüche

1. Hausgerät mit einer Hausgerätevorrichtung (12), insbesondere mit einer Gargerätevorrichtung, welche zumindest eine Elektronikeinheit (20) und zumindest eine Barriereeinheit (50, 150, 250) aufweist, die dazu vorgesehen ist, zumindest eine Elektronikbaugruppe (60, 160) der Elektronikeinheit (20) gegen zumindest einen Großteil anderer elektronischer Bauelemente der Elektronikeinheit (20) abzugrenzen, wobei die Barriereeinheit (50, 150, 250) zumindest ein Raumstrukturierungselement (70, 72, 74, 170, 172, 174, 270, 272, 274) aufweist, das dazu vorgesehen ist, einen von der Barriereeinheit (50, 150, 250) zumindest im Wesentlichen umfassten Raum zu strukturieren, wobei das zumindest eine Raumstrukturierungselement (70, 72, 74, 170, 172, 174, 270, 272, 274) dazu vorgesehen ist, zumindest in einem montierten Zustand zwei Elektronikelemente (62, 64, 66, 68, 162, 164, 166, 168) der Elektronikbaugruppe (60, 160) gegeneinander abzugrenzen, **dadurch gekennzeichnet, dass** zumindest die eine Elektronikbaugruppe (60, 160) als Schutzbaugruppe ausgebildet ist, und wobei die Schutzbaugruppe eine Elektronikbaugruppe (60, 160) ist, die dazu vorgesehen ist, zumindest einen elektrischen Schaltkreis vor einer Überspannung und/oder einem Überstrom zu schützen.

2. Hausgerät nach Anspruch 1, **dadurch gekennzeichnet, dass** das Raumstrukturierungselement (70, 72, 74, 170, 172, 174, 270, 272, 274) als aus einer Wand der Barriereeinheit (50, 150, 250) herausstehende Rippe ausgebildet ist.

3. Hausgerät nach einem der vorhergehenden Ansprüche, **dadurch gekennzeichnet, dass** die Barriereeinheit (50, 150, 250) und eine Gehäuseeinheit (14), die dazu vorgesehen ist, die Elektronikeinheit (20) zumindest großteils aufzunehmen, getrennt voneinander ausgebildet sind.

4. Hausgerät nach einem der vorhergehenden Ansprüche, **dadurch gekennzeichnet, dass** zumindest die eine Elektronikbaugruppe (60, 160) als Leiterbahnbaugruppe ausgebildet ist, wobei die Leiterbahnbaugruppe eine Elektronikbaugruppe (60, 160) ist, deren zumindest ein elektronisches Bauelement von zumindest einer Leiterbahn auf einer Leiterplatte gebildet ist.

5. Hausgerät nach einem der vorhergehenden Ansprüche, **dadurch gekennzeichnet, dass** die Barriereeinheit (50, 150, 250) zumindest ein Barriereelement (52, 152, 252) mit zumindest einem Befestigungselement (54, 56, 154, 156, 254, 256) aufweist, das dazu vorgesehen ist, die Barriereeinheit (50, 150, 250) mit der Elektronikeinheit (20) zu verbinden.

6. Hausgerät nach Anspruch 5, **dadurch gekennzeichnet, dass** das Befestigungselement (54, 56, 154, 156, 254, 256) als Rastelement ausgebildet ist.

7. Hausgerät nach einem der vorhergehenden Ansprüche, **dadurch gekennzeichnet, dass** die Barriereeinheit (50, 150, 250) zumindest in einem montierten Zustand als zumindest im Wesentlichen geschlossene Umhüllung ausgebildet ist.

8. Hausgerät nach einem der Ansprüche 1 bis 5, **dadurch gekennzeichnet, dass** die Barriereeinheit (50, 150, 250) zumindest in einem montierten Zustand als teilweise offene Umhüllung ausgebildet ist.

9. Hausgerät nach einem der vorhergehenden Ansprüche, **dadurch gekennzeichnet, dass** die Barriereeinheit (50, 150, 250) zumindest im Wesentlichen aus Kunststoff gebildet ist.

## Claims

1. Household appliance with a household appliance apparatus (12), in particular with a cooking appliance apparatus, which has at least one electronic unit (20) and at least one barrier unit (50, 150, 250), which is provided to delimit at least one electronic subassembly (60, 160) of the electronic unit (20) from at least a majority of other electronic components of the electronic unit (20), wherein the barrier unit (50, 150, 250) has at least one spatial structuring element (70, 72, 74, 170, 172, 174, 270, 272, 274), which is provided to structure a space at least substantially comprised by the barrier unit (50, 150, 250), wherein the at least one spatial structuring element (70, 72, 74, 170, 172, 174, 270, 272, 274) is provided to delimit two electronic elements (62, 64, 66, 68, 162, 164, 166, 168) of the electronic subassembly (60, 160) from one another, at least in an assembled state, **characterised in that** at least the one electronic subassembly (60, 160) is embodied as a protection subassembly, and wherein the protection subassembly is an electronic subassembly (60, 160) which is provided to protect at least one electrical circuit from an overvoltage and/or an overcurrent.

2. Household appliance according to claim 1, **characterised in that** the spatial structuring element (70, 72, 74, 170, 172, 174, 270, 272, 274) is embodied as a rib protruding from a wall of the barrier unit (50, 150, 250).

3. Household appliance according to one of the preceding claims, **characterised in that** the barrier unit (50, 150, 250) and a housing unit (14), which is provided to accommodate at least a majority of the electronic unit (20), are embodied as separated from one another.

4. Household appliance according to one of the preceding claims, **characterised in that** at least the one electronic subassembly (60, 160) is embodied as a conductor path subassembly, wherein the conductor path subassembly is an electronic subassembly (60, 160), the at least one electronic subassembly of which is formed by at least one conductor path on a circuit board.

5. Household appliance according to one of the preceding claims, **characterised in that** the barrier unit (50, 150, 250) has at least one barrier element (52, 152, 252) with at least one fastening element (54, 56, 154, 156, 254, 256), which is provided to connect the barrier unit (50, 150, 250) to the electronic unit (20).

6. Household appliance according to claim 5, **characterised in that** the fastening element (54, 56, 154, 156, 254, 256) is embodied as a latching element.

7. Household appliance according to one of the preceding claims, **characterised in that** the barrier unit (50, 150, 250) is embodied as an at least substantially closed shell, at least in an assembled state.

8. Household appliance according to one of claims 1 to 5, **characterised in that** the barrier unit (50, 150, 250) is embodied as a partially open shell, at least in an assembled state.

9. Household appliance according to one of the preceding claims, **characterised in that** the barrier unit (50, 150, 250) is at least substantially made of plastic.

## Revendications

1. Appareil ménager avec un dispositif d'appareil ménager (12), en particulier avec un dispositif d'appareil de cuisson, lequel comprend au moins une unité électronique (20) et au moins une unité de barrière (50, 150, 250), laquelle est prévue pour délimiter au moins un module électronique (60, 160) de l'unité électronique (20) par rapport à au moins une majeure partie d'autres composants électroniques de l'unité électronique (20), dans lequel l'unité de barrière (50, 150, 250) comprend au moins un élément de structuration de l'espace (70, 72, 74, 170, 172, 174, 270, 272, 274), lequel est prévu pour structurer un espace au moins essentiellement entouré par l'unité de barrière (50, 150, 250), dans lequel l'au moins un élément de structuration de l'espace (70, 72, 74, 170, 172, 174, 270, 272, 274) est prévu pour délimiter l'un par rapport à l'autre deux éléments électroniques (62, 64, 66, 68, 162, 164, 166, 168) du module électronique (60, 160) au moins dans un état monté,
**caractérisé en ce qu'**au moins ledit module électronique (60, 160) est conçu sous la forme d'un module de protection, et dans lequel le module de protection est un module électronique (60, 160), lequel est prévu pour protéger au moins un circuit électrique contre une surtension et/ou une surintensité.

2. Appareil ménager selon la revendication 1, **caractérisé en ce que** l'élément de structuration de l'espace (70, 72, 74, 170, 172, 174, 270, 272, 274) est conçu sous la forme d'une nervure faisant saillie à partir d'une paroi de l'unité de barrière (50, 150, 250).

3. Appareil ménager selon l'une des revendications précédentes, **caractérisé en ce que** l'unité de barrière (50, 150, 250) et une unité de boîtier (14), laquelle est prévue pour recevoir au moins en majeure partie l'unité électronique (20), sont conçues séparément l'une de l'autre.

4. Appareil ménager selon l'une des revendications précédentes, **caractérisé en ce qu'**au moins ledit module électronique (60, 160) est conçu sous la forme d'un module de tracé conducteur, dans lequel le module de tracé conducteur est un module électronique (60, 160), dont au moins un composant électronique est formé d'au moins un tracé conducteur sur une carte de circuits imprimés.

5. Appareil ménager selon l'une des revendications précédentes, **caractérisé en ce que** l'unité de barrière (50, 150, 250) comprend au moins un élément de barrière (52, 152, 252) avec au moins un élément de fixation (54, 56, 154, 156, 254, 256), lequel est prévu pour relier l'unité de barrière (50, 150, 250) à l'unité électronique (20).

6. Appareil ménager selon la revendication 5, **caractérisé en ce que** l'élément de fixation (54, 56, 154, 156, 254, 256) est conçu sous la forme d'un élément d'encliquetage.

7. Appareil ménager selon l'une des revendications précédentes, **caractérisé en ce que** l'unité de barrière (50, 150, 250) est conçue au moins dans un état monté sous la forme d'une enveloppe au moins essentiellement fermée.

8. Appareil ménager selon l'une des revendications 1 à 5, **caractérisé en ce que** l'unité de barrière (50, 150, 250) est conçue au moins dans un état monté sous la forme d'une enveloppe en partie ouverte.

9. Appareil ménager selon l'une des revendications précédentes, **caractérisé en ce que** l'unité de barrière (50, 150, 250) est formée au moins essentiellement à partir de matière plastique.
